# EUROPEAN PATENT APPLICATION

(11) **EP 3 432 016 A1**
(43) Date of publication of application: **23.01.2019**
(21) Application number: 16894540.0
(22) Date of filing: 15.11.2016
(51) Int. Cl.: G01R 31/36, H01M 10/42, H01M 10/44, H01M 10/48, H02J 7/00

(54) **SEALED-TYPE SECONDARY BATTERY REMAINING CAPACITY PREDICTION METHOD, REMAINING CAPACITY PREDICTION SYSTEM, BATTERY INTERNAL INFORMATION ACQUISITION METHOD, AND BATTERY CONTROL METHOD**

(30) Priority: 15.03.2016 JP 2016050456; 20.09.2016 JP 2016183538
(71) Applicant: Toyo Tire&Rubber Co., Ltd., Itami-shi Hyogo 664-0847 (JP)
(72) Inventor: FUKUDA,Takeshi, Itami-shi Hyogo 664-0847 (JP); MINAKATA,Nobuyuki, Itami-shi Hyogo 664-0847 (JP)
(74) Representative: Sajda, Wolf E.
(86) International application number: PCT/JP2016/083789
(87) International publication number: WO 2017/158923

(57) **Abstract**

A sealed secondary battery (2) remaining capacity prediction method comprising: a step of detecting deformation of a sealed secondary battery (2) during a charging/discharging cycle C1 before a time at which a remaining capacity is predicted, so as to determine a first curve representing a relationship between a charged/discharged capacity and a deformation amount of the battery; a step of determining a second curve by fitting a reference curve to the first curve; a step of detecting a deformation amount Tm of the battery during a charging/discharging cycle C2 after the cycle C1; and a step of acquiring a charged/discharged capacity Qm corresponding to the deformation amount Tm on a basis of the second curve and determining a difference between a charged/discharged capacity Qd in a completely discharged state on the second curve and the charged/discharged capacity Qm as the remaining capacity.

## Description

### TECHNICAL FIELD

The present invention relates to a method and a system for predicting a remaining capacity of a sealed secondary battery as well as to a battery internal information acquisition method and a battery control method.

### BACKGROUND ART

In recent years, a sealed secondary battery (which may be hereinafter simply referred to as "secondary battery") represented by a lithium ion secondary battery is used as a power source not only for a mobile apparatus such as a portable phone or a notebook personal computer but also for an electrically driven vehicle such as an electric automobile or a hybrid car. By repetition of charging/discharging cycle, the secondary battery becomes deteriorated, and also it becomes difficult to grasp the residual capacity accurately according as the deterioration proceeds.

Patent Document 1 discloses a method in which change in the battery voltage per predetermined period of time is successively measured while performing constant-current charging or constant-current discharging of a secondary battery, and a deterioration rate of the secondary battery is calculated on the basis of the period of time during which the change in the battery voltage is below or equal to a predetermined value.

However, such a battery voltage per predetermined period of time changes depending on a charge/discharge history up to the time point of measurement, so that the method is not suitable for use while the charging/discharging cycle are repeated, for example, for use in an environment where the battery is mounted on an electrically driven vehicle in which the charging/discharging cycle are frequently repeated.

Patent Document 2 discloses a method of calculating a charged capacity by fully charging a battery after the battery is once completely discharged, and accumulating the electric current amount of the charging current during that period. However, in actual use, it is a rare case that the battery is completely discharged, so that the method is not suitable for use while the charging/discharging cycle are repeated, for example, for use in an environment where the battery is mounted on an electrically driven vehicle in which the charging/discharging cycle are frequently repeated.

Patent Document 3 discloses a method of detecting the voltage and the internal pressure of a secondary battery and calculating a deterioration of the secondary battery by using a relationship data between the voltage and the internal pressure of a secondary battery that is not yet deteriorated and a relationship data between the internal pressure and the battery capacity of the secondary battery. However, there are cases in which the deterioration mechanism differs depending on the environment or conditions in which the secondary battery is used, so that relationship data of various patterns must be provided, and moreover, it is difficult to determine which pattern the case corresponds to.

### PRIOR ART DOCUMENTS

### PATENT DOCUMENTS

Patent Document 1 JP 2002-340 997 A
Patent Document 2 JP 2008-278 624 A
Patent Document 3 JP 2013-92 398 A

### SUMMARY OF THE INVENTION

### PROBLEMS TO BE SOLVED BY THE INVENTION

The present invention has been made in view of the aforementioned circumstances, and an object thereof is to provide a method and a system capable of predicting a remaining capacity of a sealed secondary battery in a convenient manner and at a high precision, as well as a method for acquiring battery internal information of the sealed secondary battery and a battery control method.

### MEANS FOR SOLVING THE PROBLEMS

The present invention provides a sealed secondary battery remaining capacity prediction method comprising:
a step of detecting deformation of a sealed secondary battery during a charging/discharging cycle C1 before a time point at which a remaining capacity is predicted, so as to determine a first curved line representing a relationship between a charged/discharged capacity and a deformation amount of the sealed secondary battery;
a step of determining a second curved line by performing a treatment of fitting a reference curved line, which represents a relationship between the charged/discharged capacity and the deformation amount of the sealed secondary battery in a predetermined reference state, to the first curved line;
a step of detecting a deformation amount Tm of the sealed secondary battery during a charging/discharging cycle C2 after the charging/discharging cycle C1; and
a step of acquiring a charged/discharged capacity Qm corresponding to the deformation amount Tm of the sealed secondary battery on a basis of the second curved line and determining a difference between a charged/discharged capacity Qd in a completely discharged state on the second curved line and the charged/discharged capacity Qm as the remaining capacity.

By this method, in predicting the remaining capacity of the secondary battery, the deformation amount Tm of the secondary battery is detected during the charging/discharging cycle C2 at that time point. Further, the charged/discharged capacity Qm corresponding to the deformation amount Tm is acquired on the basis of the second curved line, and the remaining capacity is predicted by the difference between the charged/discharged capacity Qd of the completely discharged state on the second curved line and the charged/discharged capacity Qm. The second curved line is obtained by performing a treatment of fitting the reference curved line to the first curved line determined in the charging/discharging cycle C1 before the charging/discharging cycle C2.

This allows that the remaining capacity of the secondary battery can be predicted in a convenient manner and at a high precision by considering the influence of deterioration caused by repetition of charging/discharging cycles, specifically, decrease in the amount of active material contributing to charging/discharging, capacity balance shift of the positive and negative electrodes brought about by side reaction, and the influence of gas swelling in the secondary battery.

It is preferable that the charging/discharging cycle C1 is within a range of 100 cycles as counted from the charging/discharging cycle C2. In enhancing the prediction precision of the remaining capacity, it is convenient that the charging/discharging cycle C1 is as close to the charging/discharging cycle C2 as possible, so that the charging/discharging cycle C1 is more preferably within a range of 50 cycles, still more preferably within a range of 10 cycles, as counted from the charging/discharging cycle C2. It is particularly preferable when the charging/discharging cycle C1 is immediately before the charging/discharging cycle C2.

It is preferable that the reference curved line is a curved line representing a relationship between a discharged capacity from a fully charged state exceeding a charging depth of 100 (%) or a charged capacity to a fully charged state exceeding a charging depth of 100 (%) and the deformation amount of the sealed secondary battery.

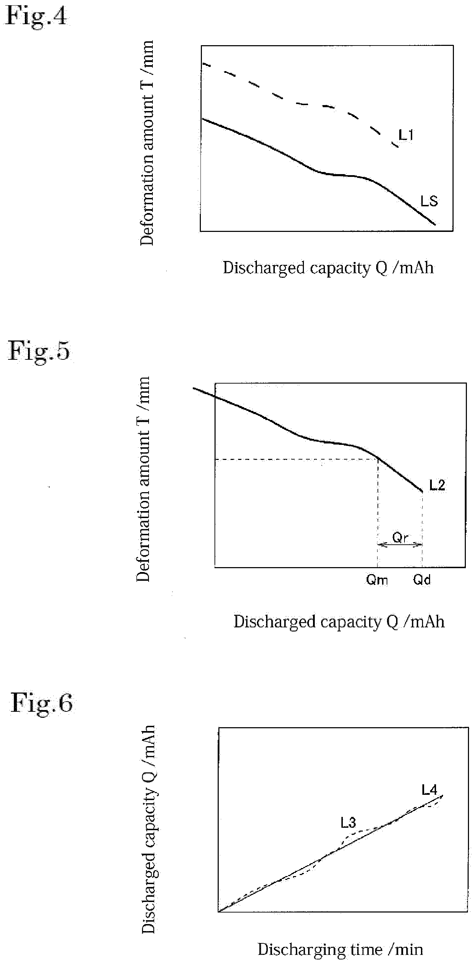

Such a method allows that, even when the fitting treatment is carried out by shifting the reference curved line to the discharge side of the charged/discharged capacity (positive direction of the X-axis in the graph of FIG. 4), the value of the second curved line determined from this is in a state of being able to exist in a neighborhood of the fully charged state, so that the remaining capacity prediction in that region can be ensured.

It is preferable that a charged/discharged capacity enlargement ratio used in performing the treatment of fitting the reference curved line to the first curved line is acquired as a retention rate of an active material. This charged/discharged capacity enlargement ratio corresponds to the ratio of the amount of active material used for charging/discharging in the charging/discharging cycle C1 relative to the amount of active material used for charging/discharging in the reference state.

Therefore, by using this as an index, the retention rate of the active material, that is, to what degree the active material contributing to the charging/discharging is retained (conversely speaking, what degree of the active material is deactivated) can be grasped, and further, the state of the secondary battery can be found out with a higher precision.

It is preferable that a charged/discharged capacity shift amount used in performing the treatment of fitting the reference curved line to the first curved line is acquired as a capacity balance shift amount of positive and negative electrodes brought about by side reaction. This charged/discharged capacity shift amount corresponds to the difference between the side reaction amount (electric current amount used for reactions other than the intercalation or deintercalation of ions) at the positive electrode and the side reaction amount at the negative electrode. Therefore, by using this as an index, the capacity balance shift amount of the positive and negative electrodes brought about by side reaction can be grasped, and further, the state of the secondary battery can be found out with a higher precision.

It is preferable that a polymer matrix layer is attached to the sealed secondary battery, and the polymer matrix layer contains a filler that is dispersed therein and that changes an external field in accordance with deformation of the polymer matrix layer; and the deformation of the sealed secondary battery is detected by detecting change in the external field accompanying the deformation of the polymer matrix layer. This allows that deformation of the sealed secondary battery can be detected with a high degree of sensitivity, and the remaining capacity of the secondary battery can be predicted with a high precision.

In the above method, it is preferable that the polymer matrix layer contains a magnetic filler as the filler, and the deformation of the sealed secondary battery is detected by detecting change in a magnetic field as the external field. This allows that change in the magnetic field accompanying the deformation of the polymer matrix layer can be wirelessly detected. Also, because a Hall element having a wide sensitivity region can be used, detection with a high degree of sensitivity can be made in a wider range.

Further, the present invention provides a sealed secondary battery remaining capacity prediction system comprising a detection sensor for detecting deformation of a sealed secondary battery and a controlling device for calculating a predicted value of a remaining capacity of the sealed secondary battery, wherein the controlling device is configured to perform:
detecting deformation of the sealed secondary battery during a charging/discharging cycle C1 before a time point at which the remaining capacity is predicted, so as to determine a first curved line representing a relationship between a charged/discharged capacity and a deformation amount of the sealed secondary battery;
determining a second curved line by performing a treatment of fitting a reference curved line, which represents a relationship between the charged/discharged capacity and the deformation amount of the sealed secondary battery in a predetermined reference state, to the first curved line;
detecting a deformation amount Tm of the sealed secondary battery during a charging/discharging cycle C2 after the charging/discharging cycle C1; and
acquiring a charged/discharged capacity Qm corresponding to the deformation amount Tm of the sealed secondary battery on a basis of the second curved line and determining a difference between a charged/discharged capacity Qd in a completely discharged state on the second curved line and the charged/discharged capacity Qm as the remaining capacity.

By this system, at the time point of predicting the remaining capacity of the secondary battery, the deformation amount Tm of the secondary battery is detected during the charging/discharging cycle C2. Further, the charged/discharged capacity Qm corresponding to the deformation amount Tm is acquired on the basis of the second curved line, and the remaining capacity is predicted by the difference between the charged/discharged capacity Qd of the completely discharged state on the second curved line and the charged/discharged capacity Qm. The second curved line is obtained by performing a treatment of fitting the reference curved line to the first curved line determined in the charging/discharging cycle C1 before the charging/discharging cycle C2.

This allows that the remaining capacity of the secondary battery can be predicted in a convenient manner and at a high precision by considering the influence of deterioration caused by repetition of charging/discharging cycles, specifically, decrease in the amount of active material contributing to charging/discharging, capacity balance shift of the positive and negative electrodes brought about by side reaction, and the influence of gas swelling in the secondary battery.

It is preferable that the charging/discharging cycle C1 is within a range of 100 cycles as counted from the charging/discharging cycle C2. In enhancing the prediction precision of the remaining capacity, it is convenient that the charging/discharging cycle C1 is as close to the charging/discharging cycle C2 as possible, so that the charging/discharging cycle C1 is more preferably within a range of 50 cycles, still more preferably within a range of 10 cycles, as counted from the charging/discharging cycle C2. It is particularly preferable when the charging/discharging cycle C1 is immediately before the charging/discharging cycle C2.

It is preferable that the reference curved line is a curved line representing a relationship between a discharged capacity from a fully charged state exceeding a charging depth of 100 (%) or a charged capacity to a fully charged state exceeding a charging depth of 100 (%) and the deformation amount of the sealed secondary battery. Such a construction allows that, even when the fitting treatment is carried out by shifting the reference curved line to the discharge side of the charged/discharged capacity (positive direction of the X-axis in the graph of FIG. 4), the value of the second curved line determined from this is in a state of being able to exist in a neighborhood of the fully charged state, so that the remaining capacity prediction in that region can be ensured.

It is preferable that the controlling device is configured to be capable of acquiring a charged/discharged capacity enlargement ratio used in performing the treatment of fitting the reference curved line to the first curved line as a retention rate of an active material. This charged/discharged capacity enlargement ratio corresponds to the ratio of the amount of active material used for charging/discharging in the charging/discharging cycle C1 relative to the amount of active material used for charging/discharging in the reference state.

Therefore, by using this as an index, the retention rate of the active material, that is, to what degree the active material contributing to the charging/discharging is retained (conversely speaking, what degree of the active material is deactivated) can be grasped, and further, the state of the secondary battery can be found out with a higher precision.

It is preferable that the controlling device is configured to be capable of acquiring a charged/discharged capacity shift amount used in performing the treatment of fitting the reference curved line to the first curved line as a capacity balance shift amount of positive and negative electrodes brought about by side reaction. This charged/discharged capacity shift amount corresponds to the difference between the side reaction amount at the positive electrode and the side reaction amount at the negative electrode. Therefore, by using this as an index, the capacity balance shift amount of the positive and negative electrodes brought about by side reaction can be grasped, and further, the state of the secondary battery can be found out with a higher precision.

It is preferable that the detection sensor comprises a polymer matrix layer bonded to the sealed secondary battery and a detection unit; the polymer matrix layer contains a filler that is dispersed therein and that changes an external field in accordance with deformation of the polymer matrix layer; and the detection unit is configured to be capable of detecting change in the external field. This allows that deformation of the sealed secondary battery can be detected with a high degree of sensitivity, and the remaining capacity of the secondary battery can be predicted with a high precision.

In the above system, it is preferable that the polymer matrix layer contains a magnetic filler as the filler, and the detection unit is configured to be capable of detecting change in a magnetic field as the external field. This allows that change in the magnetic field accompanying the deformation of the polymer matrix layer can be wirelessly detected. Also, because a Hall element having a wide sensitivity region can be used, detection with a high degree of sensitivity can be made in a wider range.

### BRIEF DESCRIPTION OF THE DRAWINGS

- FIG. 1: is a block diagram showing one example of a system for executing a remaining capacity prediction method according to the present invention.
- FIG. 2: is a view schematically illustrating a sealed secondary battery, where
- FIG. 2(a): is a perspective view, and
- FIG. 2(b): is an A-A cross-sectional view.
- FIG. 3: is a view schematically illustrating a sealed secondary battery, where
- FIG. 3(a): is a perspective view, and
- FIG. 3(b): is an B-B cross-sectional view.
- FIG. 4: is a graph showing the first curved line and the reference curved line.
- FIG. 5: is a graph showing the second curved line obtained by a fitting treatment.
- FIG. 6: is a graph showing a relationship between the discharging time and the discharged capacity.
- FIG. 7: is a graph showing a relationship between the discharging time and the remaining capacity.
- FIG. 8: is a graph showing a relationship between the discharged capacity and the electric potential and a relationship between the discharged capacity and the deformation amount of a negative electrode half-cell.
- FIG. 9: is a graph showing a relationship between the discharged capacity and the electric potential of the negative electrode half-cell after the fitting.

### MODE FOR CARRYING OUT THE INVENTION

An embodiment of the present invention will be explained.

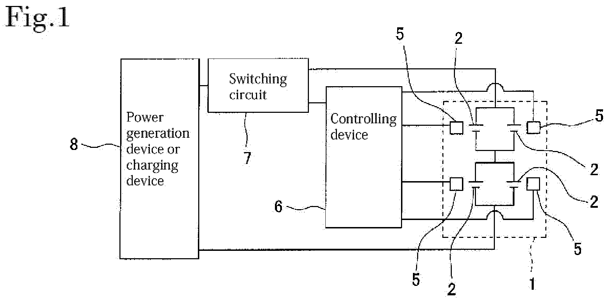

FIG. 1 shows a system that is mounted on an electrically driven vehicle such as an electric automobile or a hybrid car. This system includes a battery module 1 in which an assembled battery constructed with a plurality of sealed secondary batteries 2 is accommodated in a case. In the present embodiment, four secondary batteries 2 are connected in an arrangement of two in parallel by two in series; however, the number of batteries or the connection mode is not limited to this alone.

In FIG. 1, only one battery module 1 is shown. Actually, however, the batteries are mounted as a battery pack including a plurality of battery modules 1. In the battery pack, a plurality of battery modules 1 are connected in series, and the battery modules 1 are accommodated in a case together with various apparatus such as a controller. The case of the battery pack is formed in a shape suitable for mounting on a vehicle, for example, a shape that conforms to the under-floor shape of the vehicle.

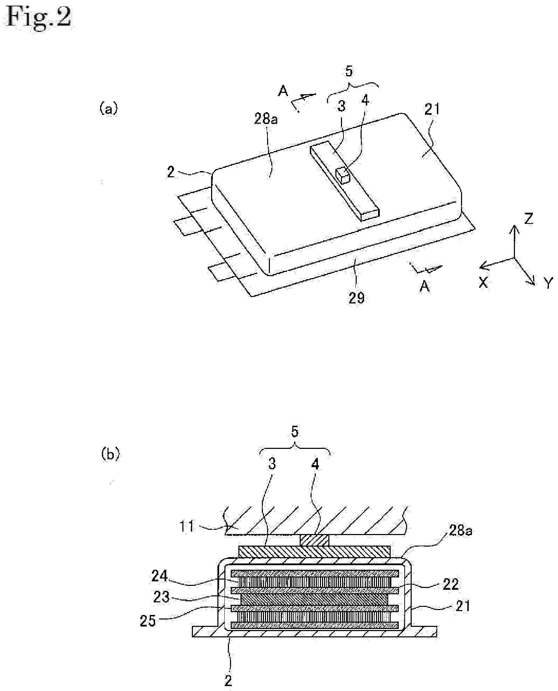

The secondary battery 2 shown in FIG. 2 is constructed as a cell (unit cell) in which an electrode group 22 is accommodated in the inside of a sealed outer casing 21. The electrode group 22 has a structure in which a positive electrode 23 and a negative electrode 24 are stacked or wound via a separator 25 interposed therebetween, and an electrolytic solution is held in the separator 25.

The secondary battery 2 of the present embodiment is a laminate battery using a laminate film such as an aluminum laminate foil as the outer casing 21, and is specifically a laminate-type lithium ion secondary battery having a capacity of 1.44 Ah. The secondary battery 2 is formed to have a thin-type rectangular parallelepiped shape as a whole.

The X-, Y-, and Z-directions correspond to the length direction, the width direction, and the thickness direction, respectively, of the secondary battery 2. Also, the Z-direction is the thickness direction of the positive electrode 23 and the negative electrode 24.

A detection sensor 5 that detects deformation of the secondary battery 2 is mounted on the secondary battery 2. The detection sensor 5 includes a polymer matrix layer 3 attached to the secondary battery 2 and a detection unit 4. The polymer matrix layer 3 contains a filler that is dispersed therein and that changes an external field in response to deformation of the polymer matrix layer 3. The polymer matrix layer 3 of the present embodiment is in a sheet form and is formed of an elastomer material that is capable of flexible deformation.

The detection unit 4 detects the change in the external field accompanying the deformation of the polymer matrix layer 3. When the secondary battery 2 swells to be deformed, the polymer matrix layer 3 is deformed in accordance therewith, and change in the external field accompanying the deformation of the polymer matrix layer 3 is detected by the detection unit 4. In this manner, deformation of the secondary battery 1 can be detected with a high degree of sensitivity.

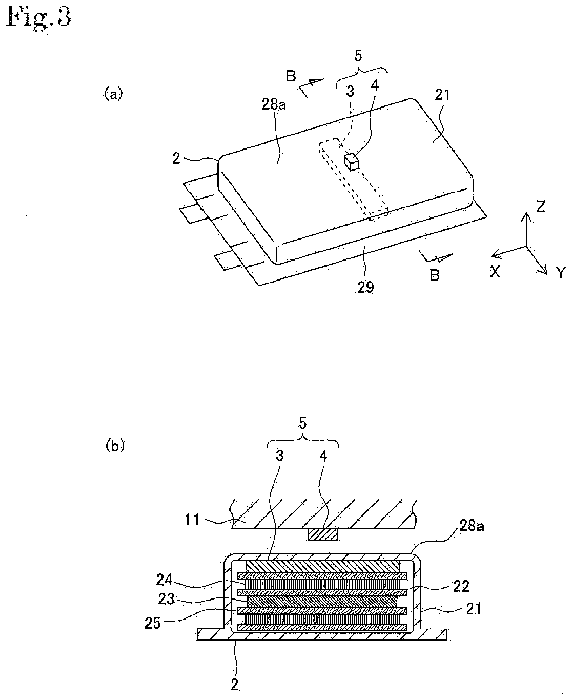

In the example shown in FIG. 2, the polymer matrix layer 3 is attached to the outer casing 21 of the secondary battery 2, so that the polymer matrix layer 3 can be deformed in accordance with the deformation (mainly the swelling) of the outer casing 21. Alternatively, the polymer matrix layer 3 may be attached to the electrode group 22 of the secondary battery 2 as shown in FIG. 3. According to such a construction, the polymer matrix layer 3 can be deformed in accordance with the deformation (mainly the swelling) of the electrode group 22. The deformation of the secondary battery 1 to be detected may be a deformation of either the outer casing 21 or the electrode group 22.

Signals obtained by detection with the detection sensor 5 are transmitted to a controlling device 6, whereby information on the deformation of the secondary battery 2 is supplied to the controlling device 6. The controlling device 6 predicts a remaining capacity of the secondary battery 2 by using the information, specifically, on the basis of the following steps 1 to 4, more preferably including the steps 5 and 6. By repetition of a charging/discharging cycle, the secondary battery 2 becomes deteriorated, and also it becomes difficult to accurately grasp the remaining capacity according as the deterioration proceeds.

Here, the charging/discharging of one cycle refers, for example, to a period from the time point at which the battery starts being used to the time point at which the battery finishes being charged by being connected to a charger, and does not include regenerative charging by a brake of an electric automobile or the like.

In the present embodiment, an example will be shown in which, by using a secondary battery 2 deteriorated by passing through 500 times of a charging/discharging cycle as an object, the remaining capacity at the 502nd charging/discharging cycle (hereafter simply referred to as "502nd cycle") is predicted.

First, deformation of the secondary battery 2 is detected during the charging/discharging cycle C1 before the time point at which the remaining capacity is predicted, so as to determine a first curved line representing a relationship between the charged/discharged capacity and the deformation amount of the secondary battery 2 (Step 1). The charging/discharging cycle C1 is selected and adopted from the charging/discharging cycles before the time point at which the remaining capacity is predicted.

In the present embodiment, the charging/discharging cycle C1 is the 501st cycle immediately before the 502nd cycle at which the remaining capacity is predicted. The charged/discharged capacity is a comprehensive nomination for the discharged capacity and the charged capacity. In the present embodiment, an example will be shown in which the charged/discharged capacity is the discharged capacity, specifically, the discharged capacity from a fully charged state.

The graph of FIG. 4 shows the first curved line L1 showing a relationship between the discharged capacity from the fully charged state and the deformation amount of the secondary battery 2, which was determined during the charging/discharging cycle C1 (501st cycle). In the charging/discharging step up to the 500th cycle, the secondary battery 2 was put into a thermostat kept at 25 °C and, after being left to stand quietly for 120 minutes, the secondary battery 2 was subjected to constant-current charging up to 4.3 V with a charging current of 1.44 A; after the voltage reached 4.3 V, the secondary battery 2 was subjected to constant-voltage charging until the electric current value decayed down to 0.07 A; thereafter, an open-circuit state was maintained for 10 minutes, and the secondary battery 2 was subjected to constant-current discharging down to 3.0 V with an electric current of 1.44 A; and a cycle of these operations was repeated for 500 times.

Further, in the charging/discharging step of the 501st cycle, the secondary battery 2 was put into a thermostat kept at 25 °C and, after being left to stand quietly for 120 minutes, the secondary battery 2 was subjected to constant-current charging up to 4.3 V with a charging current of 0.144 A. After the voltage reached 4.3 V, the secondary battery 2 was subjected to constant-voltage charging until the electric current value decayed down to 0.07 A.

Thereafter, an open-circuit state was maintained for 10 minutes, and the secondary battery 2 was subjected to constant-current discharging down to 3.0 V with an electric current of 0.144 A. Here, the discharged capacity from the fully charged state to the completely discharged state at this time was 1.27 Ah.

In the graph of FIG. 4, the lateral axis represents a discharged capacity Q with the point of origin representing a fully charged state, and the longitudinal axis represents a detected deformation amount T of the secondary battery 2. According as the discharged capacity Q from the fully charged state increases, the deformation amount T of the secondary battery 2 decreases. This is due to the following reason. In the charged secondary battery 2, swelling of the electrode group 22 (which may be hereafter referred to as "electrode swelling") is generated due to change in volume of a negative electrode active material. According as the discharging proceeds, the electrode swelling decreases.

The reference curved line LS shows a relationship between the charged/discharged capacity (discharged capacity from the fully charged state in the present embodiment) and the deformation amount of the secondary battery 2 in a predetermined reference state. The reference curved line LS is determined by using a secondary battery 2 that is in an initial stage and is not deteriorated yet as a reference state, for example, by using a secondary battery 2 just after being produced or before being shipped as an object.

Information regarding the reference curved line LS is stored in advance in a storage unit, not illustrated in the drawings, provided in the controlling device 6. In the charging/discharging step in which the reference curved line LS was determined, the secondary battery 2 before being shipped was put into a thermostat kept at 25 °C and, after being left to stand quietly for 120 minutes, the secondary battery 2 was subjected to constant-current charging up to 4.32 V with a charging current of 0.144 A.

After the voltage reached 4.32 V, the secondary battery 2 was subjected to constant-voltage charging until the electric current value decayed down to 0.07 A. Thereafter, an open-circuit state was maintained for 10 minutes, and the secondary battery 2 was subjected to constant-current discharging down to 3.0 V with an electric current of 0.144 A. The discharged capacity from the fully charged state to the completely discharged state at this time was 1.44 Ah.

In the secondary battery 2, when the electrolytic solution is decomposed due to overcharging or the like, swelling due to rise in the internal pressure caused by the decomposed gas (which may be hereafter referred to as "gas swelling") may be generated. The detection sensor 5 detects deformation of the secondary battery 2 due to this gas swelling as well; however, this is reflected merely as an overall magnitude of the deformation amount T and does not appear as a change accompanying the increase in the discharged capacity Q.

Therefore, in FIG. 4, the fact that the deformation amount T decreases in accordance with increase in the discharged capacity Q is due to the influence of the electrode swelling, while the fact that the first curved line L1 shows a larger deformation amount T than the reference curved line LS with the same discharged capacity Q is due to the influence of the gas swelling.

The first curved line L1 and the reference curved line LS have a shape including concavity and convexity (change in slope) of some degree, as shown in FIG. 4, due to stage changes of the electrode. For example, in the case of a lithium ion secondary battery using graphite (graphite) in the negative electrode, it is known that the crystal state of the graphite successively undergoes stage change according as the discharging proceeds from the fully charged state.

This is because the active material of the negative electrode expands due to stepwise increase of an average distance between the graphene layers in accordance with the amount of intercalation of lithium ions. To sum up, the volume of the active material changes stepwise by the stage change, and this is reflected on the first curved line L1 and the reference curved line LS. In determining the curved lines such as this, the detection sensor 5 that detects deformation of the secondary battery 2 with a high degree of sensitivity is suitable.

As an active material for use in the negative electrode of a lithium ion secondary battery, those capable of electrochemically intercalating and deintercalating lithium ions are used. In obtaining the first curved line L1 and the reference curved line LS having a shape including the concavity and convexity such as described above, a negative electrode containing graphite, hard carbon, soft carbon, silicon, sulfur, or the like, for example, is used, and among these, a negative electrode containing graphite is preferably used. Also, examples of the active material used in the positive electrode include LiCoO₂, LiMn₂O₄, LiNiO₂, Li(MnAl)₂O₄, Li(NiCoAl)O₂, LiFePO₄, and Li(NiMnCo)O₂.

After the above step 1, a second curved line L2 is determined by performing a treatment of fitting the reference curved line LS to the first curved line L1 (Step 2). As already described, the first curved line L1 is determined in the above step 1, and the reference curved line LS is determined in advance in a reference state before being deteriorated.

The fitting treatment can be carried out by a generally used method such as the method of least squares, and can be performed, for example, by using a software that is incorporated in numerous commercially available software packages, such as the Solver (registered trademark) in the Excel (registered trademark) manufactured by Microsoft Corporation.

The graph of FIG. 5 shows the second curved line L2 determined by the fitting treatment. In the fitting treatment, four parameters, which are the "charged/discharged capacity enlargement ratio Xr" corresponding to the enlargement ratio of the length in the X-axis direction of the reference curved line LS, the "charged/discharged capacity shift amount Xs" corresponding to the shift amount in the X-axis direction of the reference curved line LS, the "deformation amount enlargement ratio Yr" corresponding to the enlargement ratio of the length in the Y-axis direction of the reference curved line LS, and the "deformation amount shift amount Ys" corresponding to the shift amount in the Y-axis direction of the reference curved line LS, were changed.

In the present embodiment, Xr was 0.92; Xs was -0.055 Ah; Yr was 0.8; and Ys was +0.01 mm. This means that the length in the X-axis direction of the reference curved line LS was multiplied by 0.92, and the length in the Y-axis direction was multiplied by 0.8; and the reference curved line LS was shifted along the X-axis direction by -0.055 Ah and shifted along the Y-axis direction by +0.01 mm.

In the present embodiment, the reference curved line LS is shifted towards the charge side of the charged/discharged capacity (negative direction of the X-axis in the graph of FIG. 4); however, conversely, the reference curved line may sometimes be shifted towards the discharge side of the charged/discharged capacity (positive direction of the X-axis in the graph of FIG. 4). In this case, when the value of the determined second curved line is not present in a neighborhood of the fully charged state (neighborhood of the point of origin), it is difficult to predict the remaining capacity in that region.

Therefore, the reference curved line LS is preferably a curved line representing a relationship between the discharged capacity from a fully charged state exceeding the charging depth of 100 (%) (or the charged capacity to a fully charged state exceeding the charging depth of 100 (%)) and the deformation amount of the secondary battery 2, whereby the remaining capacity prediction in the neighborhood region of the fully charged state can be ensured. The charging depth exceeding 100 (%) such as described above is larger than a range of the charging depth that is assumed in actual use.

Further, the deformation amount Tm of the secondary battery 2 is detected during the charging/discharging cycle C2 after the charging/discharging cycle C1 (Step 3). As described above, the charging/discharging cycle C2 in the present embodiment is the 502nd cycle, and the deformation amount Tm is detected at an arbitrary timing at which it is wished to predict the remaining capacity during the discharging after the secondary battery 2 is once charged (not necessarily fully charged) after finishing the 501st cycle.

Here, the above step 3 need not be carried out after the above steps 1 and 2, so that the order of these steps in terms of time is not particularly limited. In other words, after the deformation amount Tm is detected in the above step 3, the above steps 1 and 2 may be carried out on the basis of the data of the charging/discharging cycle C1 before the charging/discharging cycle C2.

Referring to FIG. 5, after the above steps 1 to 3, the charged/discharged capacity Qm corresponding to the deformation amount Tm of the secondary battery 2 is acquired on the basis of the second curved line L2, and the difference between the charged/discharged capacity Qd in the completely discharged state on the second curved line L2 and the charged/discharged capacity Qm is determined as the remaining capacity Qr (Step 4).

This charged/discharged capacity Qm is a predicted value of the discharged capacity at the time point at which the deformation amount Tm is detected in the 502nd cycle, and the remaining capacity Qr obtained by subtracting the charged/discharged capacity Qm from the charged/discharged capacity Qd in the completely discharged state is the predicted value of the remaining capacity at that time point.

In this manner, the charged/discharged capacity Qm is acquired on the basis of the detected deformation amount Tm of the secondary battery 2 and the second curved line L2 determined by the fitting treatment described above, and the remaining capacity Qr is determined from the charged/discharged capacity Qm and the charged/discharged capacity Qd, so that the remaining capacity of the secondary battery 2 can be predicted in a convenient manner and at a high precision by considering the influence of deterioration caused by repetition of charging/discharging cycles, specifically, decrease in the amount of active material contributing to charging/discharging, capacity balance shift of the positive and negative electrodes brought about by side reaction, and the influence of gas swelling in the secondary battery 2. By using this, it is possible to predict, during the traveling of an electric vehicle, how many more kilometers the electric vehicle can travel.

In the charging/discharging step in which the deformation amount Tm was determined in FIG. 5, the secondary battery 2 was put into a thermostat kept at 25 °C and, after being left to stand quietly for 120 minutes, the secondary battery 2 was subjected to constant-current charging up to 4.3 V with a charging current of 1.44 A. After the voltage reached 4.3 V, the secondary battery 2 was subjected to constant-voltage charging until the electric current value decayed down to 0.07 A. Thereafter, an open-circuit state was maintained for 10 minutes, and the deformation amount Tm was acquired every time the second battery 2 was discharged for 10 seconds with an electric current of 0.144 A.

FIG. 6 is a graph showing a relationship between the discharging time and the discharged capacity of the secondary battery 2. Transition of the predicted value of the discharged capacity (discharged capacity Qm) determined by the aforementioned technique is shown by a broken line L3, and transition of the capacity that was actually discharged is shown by a solid line L4. It will be understood that the broken line L3 transitions along the solid line L4, and the discharged capacity Q at the time point at which the deformation amount Tm is detected in the 502nd cycle could be predicted at a high precision.

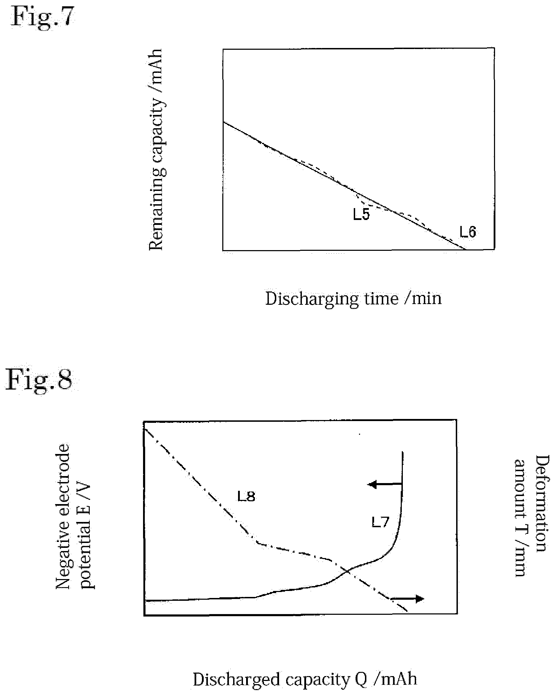

FIG. 7 is a graph showing a relationship between the discharging time and the remaining capacity of the secondary battery 2. The predicted value of the remaining capacity (remaining capacity Qr) determined by the aforementioned technique is shown by a broken line L5, and the actual remaining capacity obtained after the discharging of the 502nd cycle is finished is shown by a solid line L6. It will be understood that the broken line L5 transitions along the solid line L6, and the remaining capacity of the secondary battery 2 could be predicted at a high precision.

In the present embodiment, an example has been shown in which the charging/discharging cycle C1 is a charging/discharging cycle immediately before the charging/discharging cycle C2; however, the present invention is not limited to this alone. Nevertheless, in enhancing the prediction precision of the remaining capacity, it is convenient that the charging/discharging cycle C1 is as close to the charging/discharging cycle C2 as possible.

The charging/discharging cycle C1 is preferably within a range of 100 cycles, more preferably within a range of 50 cycles, and still more preferably within a range of 10 cycles, as counted from the charging/discharging cycle C2.

Further, from the viewpoint of preventing the fitting treatment from becoming complex, it is preferable, as in the aforementioned embodiments, that the first curved line includes concavity and convexity (change in slope) due to stage changes of the electrode, and it is desired that a charging/discharging cycle in which a first curved line having such a shape can be obtained is adopted as the charging/discharging cycle C1.

From a similar viewpoint, when the first curved line represents a relationship between the discharged capacity and the deformation amount, it is preferable that a charging/discharging cycle in which the secondary battery 2 is discharged to the completely discharged state or to a neighborhood thereof is adopted as the charging/discharging cycle C1, whereas when the first curved line represents a relationship between the charged capacity and the deformation amount, it is preferable that a charging/discharging cycle in which the secondary battery 2 is charged from the completely discharged state or from a neighborhood thereof is adopted as the charging/discharging cycle C1.

In the present embodiment, by further executing the step 5 described later, the retention rate (and the deactivation rate) of the active material is acquired, whereby the deterioration state of the secondary battery 2 can be obtained at a higher precision.

Also, by further executing the step 6 described later in addition to this or in place of this, the capacity balance shift amount of the positive and negative electrodes brought about by side reaction is acquired, whereby the deterioration state of the secondary battery 2 can be obtained at a higher precision. The steps 1 to 4 for predicting the remaining capacity and the steps 5, 6 are executed by the controlling device 6.

In predicting the remaining capacity, the charged/discharged capacity enlargement ratio Xr used in performing the treatment of fitting the reference curved line LS to the first curved line L1 is acquired as the retention rate of the active material (Step 5). In the case of a lithium ion secondary battery in which graphite is used in the negative electrode, the stage change thereof occurs when one or more lithium ions are intercalated with respect to 24 carbons and when one or more lithium ions are intercalated with respect to 12 carbons.

Decrease in the charged/discharged capacity suggests decrease in the amount of carbon capable of intercalating and deintercalating lithium ions such as this, and deactivation of the active material can be inferred on the basis of the charged/discharged capacity enlargement ratio Xr. In the present embodiment, the enlargement ratio Xr was 0.92, so that it can be diagnosed that the retention rate of the active material is 92%, that is, the negative electrode active material contributing to charging/discharging is retained by 92%.

Conversely, it can be diagnosed that the deactivation rate of the active material as determined by 1 - Xr is 8%, that is, 8% of the negative electrode active material is deactivated and can no longer be used for charging/discharging.

Also, in predicting the remaining capacity, the charged/discharged capacity shift amount Xs used in performing the treatment of fitting the reference curved line LS to the first curved line L1 is acquired as the capacity balance shift amount of the positive and negative electrodes brought about by side reaction (Step 6). The charged/discharged capacity shift amount Xs is a result of generation of a shift in the capacity balance between the positive electrode 23 and the negative electrode 24, and this shift is generated by the difference between a side reaction amount at the positive electrode 23 and a side reaction amount at the negative electrode 24.

Therefore, what degree of side reaction amount has increased in which one of the electrodes can be inferred from the shift amount Xs. When the shift amount Xs is a positive value, it can be inferred that the side reaction amount at the positive electrode 23 is larger than the side reaction amount at the negative electrode 24, whereas when the shift amount Xs is a negative value, it can be inferred that the side reaction amount at the negative electrode 24 is larger than the side reaction amount at the positive electrode 23. In the present embodiment, the shift amount Xs was -0.055 Ah, so that it can be diagnosed that the side reaction amount at the negative electrode 24 is larger than the side reaction amount at the positive electrode 23 by 0.055 Ah.

Electrochemical reaction such as decomposition of the electrolytic solution which is one factor of causing deterioration of the battery is brought about by electric potential. However, control of the battery is generally made by the voltage which is a difference between the negative electrode potential and the positive electrode potential, so that it has been difficult to obtain each of the positive and negative electrode potentials.

The graph of FIG. 8 includes a curved line L7 (corresponding to the fourth curved line) representing a relationship between the discharged capacity and the electric potential of a negative electrode half-cell and a curved line L8 (corresponding to the third curved line) representing a relationship between the discharged capacity and the deformation amount thereof. The negative electrode half-cell refers to a cell in which a negative electrode and an electrode exhibiting a constant electric potential such as lithium metal are combined. By a method similar to the fitting method described above, the curved line L8 is fit to the curved line L1 (Step 7). Illustration of a curved line obtained by this fitting treatment (corresponding to the fifth curved line) will be omitted.

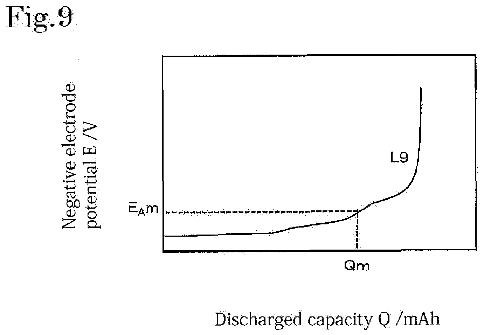

The charged/discharged capacity enlargement ratio Xr and the charged/discharged capacity shift amount Xs in the X-axis direction, which are used in performing the treatment of fitting the curved line L8 to the curved line L1, are applied to the curved line L7, so as to acquire a curved line L9 (See FIG. 9, corresponding to the sixth curved line) representing a relationship between the discharged capacity and the electric potential of the negative electrode half-cell after the fitting (Step 8).

A negative electrode potential E_{A}m corresponding to the charged/discharged capacity Qm acquired in the above step 4 is acquired on the basis of the curved line L9 (Step 9).

A positive electrode potential E_{C}m is acquired by subtracting the negative electrode potential E_{A}m from the battery voltage V acquired at the time of the deformation amount Tm described above (Step 10).

By the above method, each of the positive electrode and negative electrode potentials can be acquired, though only the battery voltage could be acquired by a general controlling method.

By using the battery in such a manner that the negative electrode potential E_{A}m or the positive electrode potential E_{C}m is within a range of value (value of positive electrode potential) that has been set in advance, the side reaction at the positive electrode or the negative electrode can be suppressed, whereby the lifetime of the battery can be improved.

In the above-described embodiment, the first curved line L1 and the reference curved line LS represent the relationship between the discharged capacity (specifically, the discharged capacity from the fully charged state) and the deformation amount of the secondary battery 2; however, the present invention is not limited to this, so that the first curved line L1 and the reference curved line LS may represent a relationship between the charged capacity (for example, the charged capacity to the fully charged state) and the deformation amount of the secondary battery. In this case as well, the remaining capacity of the secondary battery can be predicted according to a procedure similar to the one described above.

In the embodiment shown in FIG. 2, the polymer matrix layer 3 is attached to a wall part 28a of the outer casing 21 that faces the electrode group 22 in the thickness direction of the positive electrode 23 and the negative electrode 24, that is, in the Z-direction (up-and-down direction in FIG. 2(b)). The outer surface of the wall part 28a corresponds to the upper surface of the outer casing 21.

The polymer matrix layer 3 faces the electrode group 22 with the wall part 28a interposed therebetween, and is disposed parallel to the upper surface of the electrode group 22. The electrode swelling is caused by a change in the thickness of the electrode group 22 accompanying the change in volume of the active material, so that the action in the Z-direction is large.

Therefore, in the present embodiment in which the polymer matrix layer 3 is attached to the wall part 28a, the electrode swelling can be detected with a high degree of sensitivity and, as a result, the remaining capacity of the secondary battery 2 can be predicted at a high precision.

In the embodiment shown in FIG. 3, the polymer matrix layer 3 is attached in the thickness direction of the positive electrode 23 and the negative electrode 24, that is, in the Z-direction (up-and-down direction in FIG. 3(b)), relative to the electrode group 22. This allows that, even when the outer casing is formed of a robust material such as a metal can, the swelling of the electrode group 22 thereof, that is, the electrode swelling, can be detected with a high degree of precision and, as a result, the remaining capacity of the secondary battery 2 can be predicted at a high precision.

The detection unit 4 is disposed at a site where the change in the external field can be detected, and is preferably attached to a comparatively firm site that is hardly affected by the swelling of the secondary battery 2. In the present embodiment, the detection unit 4 is attached to an inner surface of a case 11 of the battery module that faces the wall portion 28a, as shown in FIG. 2(b).

The case 11 of a battery module is formed, for example, of a metal or a plastic, and there may be cases in which a laminate film is used as the case 11 of the battery module. In the drawings, the detection unit 4 is disposed close to the polymer matrix layer 3; however, the detection unit 4 may be disposed to be distant from the polymer matrix layer 3.

The present embodiment is an example in which the polymer matrix layer 3 contains a magnetic filler as the above-described filler, and the detection unit 4 detects change in a magnetic field as the above-described external field. In this case, the polymer matrix layer 3 is preferably a magnetic elastomer layer in which the magnetic filler is dispersed in a matrix that contains an elastomer component.

The magnetic filler may be, for example, a rare-earth-based, iron-based, cobalt-based, nickel-based, or oxide-based filler; however, a rare-earth-based filler is preferable because a higher magnetic force can be obtained. The shape of the magnetic filler is not particularly limited, so that the shape may be any one of spherical, flattened, needle-like, prismatic, and amorphous shapes. The average particle size of the magnetic filler is preferably from 0.02 µm to 500 µm, more preferably from 0.1 µm to 400 µm, and still more preferably from 0.5 µm to 300 µm. When the average particle size is smaller than 0.02 µm, the magnetic characteristics of the magnetic filler tend to deteriorate. On the other hand, when the average particle size exceeds 500 µm, the mechanical properties of the magnetic elastomer layer tend to deteriorate, and the magnetic elastomer layer tends to be brittle.

The magnetic filler may be introduced into the elastomer after magnetization; however, it is preferable to magnetize the magnetic filler after introduction into the elastomer. By magnetization after introduction into the elastomer, the polarity of the magnet can be easily controlled, and the magnetic field can be easily detected.

A thermoplastic elastomer, a thermosetting elastomer, or a mixture of these can be used as the elastomer component. Examples of the thermoplastic elastomer include a styrene-based thermoplastic elastomer, a polyolefin-based thermoplastic elastomer, a polyurethane-based thermoplastic elastomer, a polyester-based thermoplastic elastomer, a polyamide-based thermoplastic elastomer, a polybutadiene-based thermoplastic elastomer, a polyisoprene-based thermoplastic elastomer, and a fluororubber-based thermoplastic elastomer.

Also, examples of the thermosetting elastomer include diene-based synthetic rubbers such as polyisoprene rubber, polybutadiene rubber, styrene-butadiene rubber, polychloroprene rubber, nitrile rubber, and ethylene-propylene rubber, non-diene-based synthetic rubbers such as ethylene-propylene rubber, butyl rubber, acrylic rubber, polyurethane rubber, fluororubber, silicone rubber, and epichlorohydrin rubber, and natural rubbers.

Among these, a thermosetting elastomer is preferable, and this is because settling of the magnetic elastomer accompanying the heat generation or overloading of the battery can be suppressed. Further, a polyurethane rubber (which may also be referred to as a polyurethane elastomer) or a silicone rubber (which may also be referred to as a silicone elastomer) is more preferable.

A polyurethane elastomer can be obtained by reacting a polyol with a polyisocyanate. In the case in which the polyurethane elastomer is used as the elastomer component, a magnetic filler is mixed with a compound containing active hydrogen, and further an isocyanate component is added thereto to obtain a mixture liquid.

Also, a mixture liquid can also be obtained by mixing a magnetic filler with an isocyanate component, and mixing a compound containing active hydrogen thereto. The magnetic elastomer can be produced by injecting the mixture liquid into a mold that has been subjected to a releasing treatment, and thereafter heating the mixture liquid up to a curing temperature for curing.

Also, in the case in which a silicone elastomer is used as the elastomer component, the magnetic elastomer can be produced by putting a magnetic filler into a precursor of a silicone elastomer, mixing the components, putting the resulting mixture into a mold, and thereafter heating the mixture for curing. A solvent may be added as necessary.

A compound known in the art in the field of polyurethane can be used as the isocyanate component that can be used in the polyurethane elastomer. Examples of the isocyanate component include aromatic diisocyanates such as 2,4-toluene diisocyanate, 2,6-toluene diisocyanate, 2,2'-diphenylmethane diisocyanate, 2,4'-diphenylmethane diisocyanate, 4,4'-diphenylmethane diisocyanate, 1,5-naphthalene diisocyanate, p-phenylene diisocyanate, m-phenylene diisocyanate, p-xylylene diisocyanate, and m-xylylene diisocyanate, aliphatic diisocyanates such as ethylene diisocyanate, 2,2,4-trimethylhexamethylene diisocyanate, and 1,6-hexamethylene diisocyanate, and alicyclic diisocyanates such as 1,4-cyclohexane diisocyanate, 4,4'-dicyclohexylmethane diisocyanate, isophorone diisocyanate, and norbornane diisocyanate.

These may be used either alone or as a mixture of two or more kinds. Also, the isocyanate component may be a modified component such as a urethane-modified, allophanate-modified, biuret-modified, or isocyanurate-modified component. Preferable isocyanate components are 2,4-toluene diisocyanate, 2,6-toluene diisocyanate, and 4,4'-diphenylmethane diisocyanate. 2,4-toluene diisocyanate or 2,6-toluene diisocyanate is more preferable.

A compound typically used in the technical field of polyurethane can be used as the compound containing active hydrogen. Examples of the compound containing active hydrogen include high-molecular-weight polyols such as polyether polyols represented by polytetramethylene glycol, polypropylene glycol, polyethylene glycol, and a copolymer of propylene oxide and ethylene oxide, polyester polyols represented by polybutylene adipate, polyethylene adipate, and 3-methyl-1,5-pentane adipate, polyester polycarbonate polyols typified by reaction products of alkylene carbonate and polyester glycol such as polycaprolactone polyol or polycaprolactone, polyester polycarbonate polyols obtained by reacting ethylene carbonate with a polyhydric alcohol and subsequently reacting the obtained reaction mixture with an organic dicarboxylic acid, and polycarbonate polyols obtained by transesterification reaction of a polyhydroxyl compound and aryl carbonate. These may be used either alone or as a mixture of two or more kinds.

In addition to the above-described high-molecular-weight polyol components, low-molecular-weight polyol components such as ethylene glycol, 1,2-propylene glycol, 1,3-propylene glycol, 1,4-butanediol, 1,6-hexanediol, neopentyl glycol, 1,4-cyclohexanedimethanol, 3-methyl-1,5-pentanediol, diethylene glycol, triethylene glycol, 1,4-bis(2-hydroxyethoxy)benzene, trimethylolpropane, glycerin, 1,2,6-hexanetriol, pentaerythritol, tetramethylolcyclohexane, methylglucoside, sorbitol, mannitol, dulcitol, sucrose, 2,2,6,6-tetrakis(hydroxymethyl)cyclohexanol, and triethanolamine, and low-molecular-weight polyamine components such as ethylenediamine, tolylenediamine, diphenylmethanediamine, and diethylenetriamine may be used as the compound containing active hydrogen.

These may be used either alone or as a mixture of two or more kinds. Further, polyamines typified by 4,4'-methylenebis(o-chloroaniline) (MOCA), 2,6-dichloro-p-phenylenediamine, 4,4'-methylenebis(2,3-dichloroaniline), 3,5-bis(methylthio)-2,4-toluenediamine, 3,5-bis(methylthio)-2,6-toluenediamine, 3,5-diethyltoluene-2,4-diamine, 3,5-diethyltoluene-2,6-diamine, trimethyleneglycol-di-p-aminobenzoate, polytetramethyleneoxide-di-p-aminobenzoate, 1,2-bis(2-aminophenylthio)ethane, 4,4'-diamino-3,3'-diethyl-5,5'-dimethyldiphenylmethane, N,N'-di-sec-butyl-4,4'-diaminodiphenylmethane, 4,4'-diamino-3,3'-diethyldiphenylmethane, 4,4'-diamino-3,3'-diethyl-5,5'-dimethyldiphenylmethane, 4,4'-diamino-3,3'-diisopropyl-5,5'-dimethyldiphenylmethane, 4,4'-diamino-3,3',5,5'-tetraethyldiphenylmethane, 4,4'-diamino-3,3',5,5'-tetraisopropyldiphenylmethane, m-xylylenediamine, N,N'-di-sec-butyl-p-phenylenediamine, m-phenylenediamine, and p-xylylenediamine may also be mixed.

Preferable compounds containing active hydrogen are polytetramethylene glycol, polypropylene glycol, a copolymer of propylene oxide and ethylene oxide, and 3-methyl-1,5-pentane adipate. More preferable compounds containing active hydrogen are polypropylene glycol and a copolymer of propylene oxide and ethylene oxide.

A preferable combination of the isocyanate component and the compound containing active hydrogen is a combination of one kind or two more kinds of 2,4-toluene diisocyanate, 2,6-toluene diisocyanate, and 4,4'-diphenylmethane diisocyanate as the isocyanate component and one kind or two more kinds of polytetramethylene glycol, polypropylene glycol, a copolymer of propylene oxide and ethylene oxide, and 3-methyl-1,5-pentane adipate as the compound containing active hydrogen. A more preferable combination is a combination of 2,4-toluene diisocyanate and/or 2,6-toluene diisocyanate as the isocyanate component and polypropylene glycol and/or a copolymer of propylene oxide and ethylene oxide as the compound containing active hydrogen.

The polymer matrix layer 3 may be a foamed body containing a dispersed filler and bubbles. A general resin foam can be used as the foamed body. However, in view of the characteristics such as compression set, it is preferable to use a thermosetting resin foam. Examples of the thermosetting resin foam include polyurethane resin foam and silicone resin foam. Among these, polyurethane resin foam is preferable. The isocyanate component and the compound containing active hydrogen that have been listed above can be used for the polyurethane resin foam.

The amount of the magnetic filler in the magnetic elastomer is preferably 1 to 450 parts by weight, more preferably 2 to 400 parts by weight, relative to 100 parts by weight of the elastomer component. When the amount is smaller than 1 part by weight, detection of change in the magnetic field tends to be difficult. When the amount exceeds 450 parts by weight, the magnetic elastomer itself may in some cases become brittle.

For the purpose of preventing rusts of the magnetic filler or the like, a sealing material for sealing the polymer matrix layer 3 may be provided to such a degree that the flexibility of the polymer matrix layer 3 is not deteriorated. A thermoplastic resin, a thermosetting resin, or a mixture of these may be used as the sealing material. The thermoplastic resin may be, for example, styrene-based thermoplastic elastomer, polyolefin-based thermoplastic elastomer, polyurethane-based thermoplastic elastomer, polyester-based thermoplastic elastomer, polyamide-based thermoplastic elastomer, polybutadiene-based thermoplastic elastomer, polyisoprene-based thermoplastic elastomer, fluorine-based thermoplastic elastomer, ethylene-ethyl acrylate copolymer, ethylene-vinyl acetate copolymer, polyvinyl chloride, polyvinylidene chloride, chlorinated polyethylene, fluororesin, polyamide, polyethylene, polypropylene, polyethylene terephthalate, polybutylene terephthalate, polystyrene, polybutadiene, or the like.

The thermosetting resin may be, for example, diene-based synthetic rubbers such as polyisoprene rubber, polybutadiene rubber, styrene-butadiene rubber, polychloroprene rubber, and acrylonitrile-butadiene rubber, non-diene-based rubbers such as ethylene·propylene rubber, ethylene-propylene-diene rubber, butyl rubber, acrylic rubber, polyurethane rubber, fluorine-containing rubber, silicone rubber, and epichlorohydrin rubber, natural rubbers, and thermosetting resins such as polyurethane resin, silicone resin, epoxy resin, or the like. These films may be stacked or may be a film including a metal foil such as aluminum foil or a metal vapor-deposition film including a metal vapor-deposited on the above-described film.

The polymer matrix layer 3 may be one in which the filler is unevenly distributed in the thickness direction thereof. For example, the polymer matrix layer 3 may be made of two layers, that is, a region on a one side containing a relatively larger amount of the filler and a region on the other side containing a relatively smaller amount of the filler. In the region that is located on the one side and that contains a larger amount of the filler, a large change in the external field results from small deformation of the polymer matrix layer 3, so that the sensor sensitivity to a low internal pressure can be enhanced.

Also, a region that is located on the other side and that contains a relatively smaller amount of the filler is comparatively flexible and can be easily moved. Therefore, by attaching this region located on the other side, the polymer matrix layer 3 (particularly the region located on the one side) becomes capable of being easily deformed.

The filler uneven distribution ratio in the region on the one side preferably exceeds 50, and is more preferably 60 or more, still more preferably 70 or more. In this case, the filler uneven distribution ratio in the region on the other side is less than 50. The filler uneven distribution ratio in the region on the one side is 100 at the maximum, and the filler uneven distribution ratio in the region on the other side is 0 at the minimum.

Therefore, it is possible to adopt a stacked body structure including an elastomer layer that contains a filler and an elastomer layer that does not contain the filler. For uneven distribution of the filler, it is possible to use a method in which, after the filler is introduced into the elastomer component, the resultant is left to stand still at room temperature or at a predetermined temperature, so as to attain natural settling of the filler by the weight of the filler.

By changing the temperature or time for leaving the filler to stand still, the filler uneven distribution ratio can be adjusted. The filler may be distributed unevenly by using a physical force such as a centrifugal force or a magnetic force. Alternatively, the polymer matrix layer may be composed of a stacked body made of a plurality of layers having different contents of the filler.

The filler uneven distribution ratio is measured by the following method. That is, the cross-section of the polymer matrix layer is observed at a magnification of 100 times by using a scanning electron microscope - energy dispersive X-ray analyzer (SEM-EDS). The existence amount of the metal element inherent in the filler (for example, Fe element in the magnetic filler of the present embodiment) is determined by element analysis for the whole region in the thickness direction of the cross-section and for each of the two regions obtained by equally dividing the cross-section into two in the thickness direction.

With respect to this existence amount, the ratio of the existence amount in the region on the one side relative to the existence amount in the whole region in the thickness direction is calculated, and this is determined as the filler uneven distribution ratio in the region on the one side. The filler uneven distribution ratio in the region on the other side can be determined in the same manner.

The region on the other side containing a relatively smaller amount of the filler may have a structure formed of a foamed body containing bubbles. This allows that the polymer matrix layer 3 can be more easily deformed, so that the sensor sensitivity is enhanced. Also, the region on the one side as well as the region on the other side may be formed of a foamed body. In this case, the whole of the polymer matrix layer 3 is made of a foamed body.

The polymer matrix layer in which at least a part thereof in the thickness direction is made of a foamed body may be composed of a stacked body including a plurality of layers (for example, a non-foamed layer that contains a filler and a foamed layer that does not contain a filler).

As the detection unit 4 for detecting change in the magnetic field, a magnetic resistance element, a Hall element, an inductor, an MI element, a flux gate sensor, or the like can be used, for example. As the magnetic resistance element, a semiconductor compound magnetic resistance element, an anisotropic magnetic resistance element (AMR), a gigantic magnetic resistance element (GMR), and a tunnel magnetic resistance element (TMR) may be mentioned as examples. Among these, a Hall element is preferable, and this is because the Hall element has high sensitivity in a wide range, and is useful as the detection unit 4. As the Hall element, EQ-430L manufactured by Asahi Kasei Microdevices Corporation can be used, for example.

A secondary battery 2 in which gas swelling has proceeded may reach troubles such as ignition or rupture, so that the present embodiment is constructed in such a manner that the charging/discharging is shut off when an expansion amount at the time of deformation of the secondary battery 2 is above or equal to a predetermined level.

Specifically, signals obtained by detection with the detection sensor 5 are transmitted to the controlling device 6 and, when a change in the external field above or equal to a set value is detected by the detection sensor 5, the controlling device 6 sends signals to the switching circuit 7 and shuts off the electric current from the power generation device (or charging device) 8, so as to bring the system into a state in which charging/discharging of the battery module 1 is shut off. This allows that the troubles caused by gas swelling can be prevented.

In the above-described embodiment, an example in which the secondary battery is a lithium ion secondary battery has been shown; however, the present invention is not limited to this alone. The secondary battery that is put to use is not limited to a non-aqueous electrolyte secondary battery such as a lithium ion battery, but may be an aqueous electrolyte secondary battery such as a nickel hydrogen battery.

In the embodiments, an example has been shown in which change in the magnetic field accompanying the deformation of the polymer matrix layer is detected with the detection unit; however, it is possible to adopt a construction in which change in another external field is detected. For example, a construction may be considered in which the polymer matrix layer contains an electroconductive filler such as metal particles, carbon black, or carbon nanotubes as the filler, and the detection unit detects change in the electric field (change in the resistance and the dielectric constant) as the external field.

The present invention is not limited to the embodiment mentioned above, but can be improved and modified variously within the scope of the present invention.

### DESCRIPTION OF REFERENCE SIGNS

- 1: Battery module
- 2: Sealed secondary battery
- 3: Polymer matrix layer
- 4: Detection unit
- 5: Detection sensor
- 6: Controlling device
- 7: Switching circuit
- 8: Power generation device or charging device
- 21: Outer casing
- 22: Electrode group
- 23: Positive electrode
- 24: Negative electrode
- 25: Separator
- L1: First curved line
- L2: Second curved line
- LS: Reference curved line
- L7: Third curved line
- L8: Fourth curved line
- L9: Sixth curved line

## Claims

1. A sealed secondary battery remaining capacity prediction method comprising:
- a step of detecting deformation of a sealed secondary battery (2) during a charging/discharging cycle C1 before a time point at which a remaining capacity is predicted, so as to determine a first curved line (L1) representing a relationship between a charged/discharged capacity and a deformation amount of the sealed secondary battery (2);
- a step of determining a second curved line (L2) by performing a treatment of fitting a reference curved line (LS), which represents a relationship between the charged/discharged capacity and the deformation amount of the sealed secondary battery (2) in a predetermined reference state, to the first curved line (L1);
- a step of detecting a deformation amount Tm of the sealed secondary battery (2) during a charging/discharging cycle C2 after the charging/discharging cycle C1; and
- a step of acquiring a charged/discharged capacity Qm corresponding to the deformation amount Tm of the sealed secondary battery (2) on a basis of the second curved line (L2) and determining a difference between a charged/discharged capacity Qd in a completely discharged state on the second curved line (L2) and the charged/discharged capacity Qm as the remaining capacity.

2. The sealed secondary battery remaining capacity prediction method according to claim 1,
wherein the charging/discharging cycle C1 is within a range of 100 cycles as counted from the charging/discharging cycle C2.

3. The sealed secondary battery remaining capacity prediction method according to claim 1 or 2,
wherein the reference curved line (LS) is a curved line representing a relationship between a discharged capacity from a fully charged state exceeding a charging depth of 100 (%) or a charged capacity to a fully charged state exceeding a charging depth of 100 (%) and the deformation amount of the sealed secondary battery (2).

4. The sealed secondary battery remaining capacity prediction method according to any one of claims 1 to 3,
wherein a charged/discharged capacity enlargement ratio used in performing the treatment of fitting the reference curved line (LS) to the first curved line (L1) is acquired as a retention rate of an active material.

5. The sealed secondary battery remaining capacity prediction method according to any one of claims 1 to 4,
wherein a charged/discharged capacity shift amount used in performing the treatment of fitting the reference curved line (LS) to the first curved line (L1) is acquired as a capacity balance shift amount of positive and negative electrodes (23, 24) brought about by side reaction.

6. The sealed secondary battery deterioration diagnosis method according to any one of claims 1 to 5,
wherein a polymer matrix layer (3) is attached to the sealed secondary battery (2), and the polymer matrix layer (3) contains a filler that is dispersed therein and that changes an external field in accordance with deformation of the polymer matrix layer (3); and
the deformation of the sealed secondary battery (2) is detected by detecting change in the external field accompanying the deformation of the polymer matrix layer (3).

7. The sealed secondary battery deterioration diagnosis method according to claim 6,
wherein the polymer matrix layer (3) contains a magnetic filler as the filler, and wherein the deformation of the sealed secondary battery (2) is detected by detecting change in a magnetic field as the external field.

8. A sealed secondary battery remaining capacity prediction system comprising a detection sensor (5) for detecting deformation of a sealed secondary battery (2) and a controlling device (6) for calculating a predicted value of a remaining capacity of the sealed secondary battery (2), wherein
the controlling device (6) is configured to perform:
- detecting deformation of the sealed secondary battery (2) during a charging/discharging cycle C1 before a time point at which the remaining capacity is predicted, so as to determine a first curved line (L1) representing a relationship between a charged/discharged capacity and a deformation amount of the sealed secondary battery (2);
- determining a second curved line (L2) by performing a treatment of fitting a reference curved line (LS), which represents a relationship between the charged/discharged capacity and the deformation amount of the sealed secondary battery (2) in a predetermined reference state, to the first curved line (L1);
- detecting a deformation amount Tm of the sealed secondary battery (2) during a charging/discharging cycle C2 after the charging/discharging cycle C1; and
- acquiring a charged/discharged capacity Qm corresponding to the deformation amount Tm of the sealed secondary battery (2) on the basis of the second curved line (L2) and determining a difference between a charged/discharged capacity Qd in a completely discharged state on the second curved line (L2) and the charged/discharged capacity Qm as the remaining capacity.

9. The sealed secondary battery remaining capacity prediction system according to claim 8,
wherein the charging/discharging cycle C1 is within a range of 100 cycles as counted from the charging/discharging cycle C2.

10. The sealed secondary battery remaining capacity prediction system according to claim 8 or 9,
wherein the reference curved line (LS) is a curved line representing a relationship between a discharged capacity from a fully charged state exceeding a charging depth of 100 (%) or a charged capacity to a fully charged state exceeding a charging depth of 100 (%) and the deformation amount of the sealed secondary battery (2).

11. The sealed secondary battery remaining capacity prediction system according to any one of claims 8 to 10,
wherein the controlling device (6) is configured to be capable of acquiring a charged/discharged capacity enlargement ratio used in performing the treatment of fitting the reference curved line (LS) to the first curved line (L1) as a retention rate of an active material.

12. The sealed secondary battery remaining capacity prediction system according to any one of claims 8 to 11,
wherein the controlling device (6) is configured to be capable of acquiring a charged/discharged capacity shift amount used in performing the treatment of fitting the reference curved line (LS) to the first curved line (L1) as a capacity balance shift amount of positive and negative electrodes (23, 24) brought about by side reaction.

13. The sealed secondary battery remaining capacity prediction system according to any one of claims 8 to 12,
wherein
the detection sensor (5) comprises a polymer matrix layer (3) bonded to the sealed secondary battery (2) and a detection unit (4);
the polymer matrix layer (3) contains a filler that is dispersed therein and is capable of changing an external field in accordance with deformation of the polymer matrix layer (3); and
the detection unit (4) is configured to be capable of detecting change in the external field.

14. The sealed secondary battery remaining capacity prediction system according to claim 13,
wherein the polymer matrix layer (3) contains a magnetic filler as the filler, and the detection unit (4) is configured to be capable of detecting change in a magnetic field as the external field.

15. A sealed secondary battery internal information acquisition method comprising:
- a step of detecting deformation of a sealed secondary battery (2) during a charging/discharging cycle C1 before a time point at which a remaining capacity is predicted, so as to determine a first curved line (L1) representing a relationship between a charged/discharged capacity and a deformation amount of the sealed secondary battery (2);
- a step of determining a second curved line (L2) by performing a treatment of fitting a reference curved line (LS), which represents a relationship between the charged/discharged capacity and the deformation amount of the sealed secondary battery (2) in a predetermined reference state, to the first curved line (L1);
- a step of detecting a deformation amount Tm of the sealed secondary battery (2) during a charging/discharging cycle C2 after the charging/discharging cycle C1;
- a step of acquiring a charged/discharged capacity Qm corresponding to the deformation amount Tm of the sealed secondary battery (2) on a basis of the second curved line (L2);
- a step of performing a treatment of fitting, from among a third curved line (L7) representing a relationship between a charged/discharged capacity Q and a deformation amount T of a negative electrode acquired from a half cell and a fourth curved line (L8) representing a relationship between a negative electrode potential E and a charged/discharged capacity Q of a negative electrode acquired from a half cell, the third curved line (L7) to the first curved line (LI), so as to determine a fifth curved line;
- a step of applying a shift amount and an enlargement ratio of the charged/discharged capacity Q, which are used in performing the treatment of fitting the third curved line (L7) to the first curved line (LI), to the relationship between the negative electrode potential E and the charged/discharged capacity Q of the fourth curved line, so as to determine a sixth curved line (L9);
- a step of acquiring a negative electrode potential E_{A}m corresponding to the charged/discharged capacity Qm of the sealed secondary battery (2) on a basis of the sixth curved line (L9); and
- a step of acquiring a positive electrode potential E_{C}m by subtracting a value of the negative electrode potential E_{A}m from a value of a battery voltage V.

16. A battery control method using the sealed secondary battery internal information acquisition method according to claim 15,
wherein the battery is used in such a manner that the negative electrode potential E_{A}m or the positive electrode potential E_{C}m is within a range of the positive electrode potential that has been set in advance.
